(19) Europäisches Patentamt / European Patent Office / Office européen des brevets

(11) **EP 1 772 541 B1**

(12) **EUROPEAN PATENT SPECIFICATION**

(45) Date of publication and mention
of the grant of the patent:
**27.06.2012 Bulletin 2012/26**

(51) Int Cl.:
***C30B 29/40*** *(2006.01)*      ***H01L 21/20*** *(2006.01)*

(21) Application number: **06121899.6**

(22) Date of filing: **06.10.2006**

(54) **Gallium nitride thin film on sapphire substrate having reduced bending deformation and method for its manufacture**

Galliumnitriddünnschicht auf einem Saphirsubstrat mit reduzierter Verformung und Verfahren zu ihrer Herstellung

Couche mince de nitrure de gallium sur un substrat de saphir présentant une déformation réduite et méthode de sa fabrication

(84) Designated Contracting States:
**DE FR SE**

(30) Priority: **07.10.2005 KR 20050094184**

(43) Date of publication of application:
**11.04.2007 Bulletin 2007/15**

(73) Proprietor: **Samsung Corning Precision Materials Co., Ltd.**
**Gumi-si**
**Gyeongsangbuk-do 730-360 (KR)**

(72) Inventors:
• **Lee, Chang Ho**

 **Seocho-gu**
 **137-797, Seoul (KR)**

• **Kong Sun Hwan**
 **211-1606, Hyundae Apt., Banwol-ri**
 **445-983, Kyungki-do (KR)**

(74) Representative: **Bokinge, Ole et al**
**Awapatent AB**
**Junkersgatan 1**
**582 35 Linköping (SE)**

(56) References cited:
**EP-A2- 0 966 047      US-A1- 2005 167 683**
**US-B1- 6 528 394**

**Description**

BACKGROUND OF THE INVENTION

1. Field of the Invention

The present invention relates to a gallium nitride thin film on sapphire substrate having reduced bending deformation.

2. Description of the Related Art

Generally, a gallium nitride thin film is formed such that a gallium nitride film is grown on a sapphire substrate at a relatively low temperature and the growth is finally completed at a relatively high temperature. However, a bending occurs in the sapphire substrate due to a difference (about 16%) in lattice constants and a difference (about 35%) in thermal expansion coefficients between sapphire and gallium nitride.

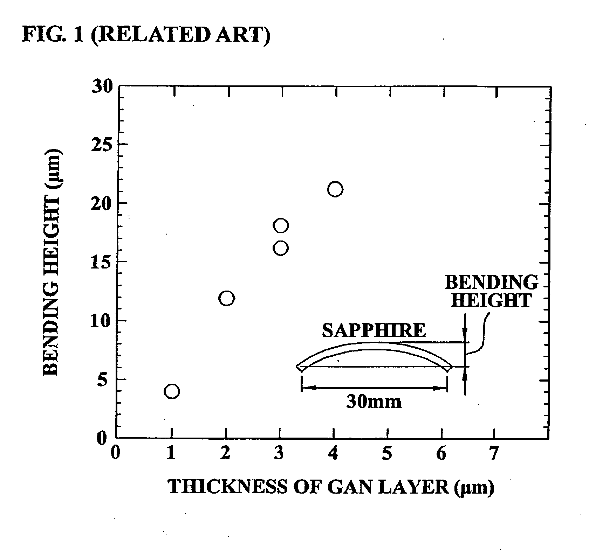

FIG 1 is a graph illustrating a bending range depending on a thickness of a gallium nitride thin film on sapphire substrate according to the related art. Referring to FIG 1, it can be seen that a curvature radius is reduced as a bending range increases due to an increase of film thickness. Such bending causes the difference in crystalline characteristics between a center portion of a substrate and a periphery of the substrate, wherein a gallium nitride thin film is grown on the substrate. In the case where a light emitting diode is manufactured by using such a substrate, a problem occurs in that a light emitting wavelength becomes uneven in the substrate. Recently, a gallium nitride film, which is used as a lower substrate for a light emitting diode and an electronic device, requires an increase in thickness to reduce defect density and increase crystalline characteristics. However, in this case, problems occur in that uniformity in device quality of a substrate is reduced due to an increase of bending deformation, thus, yield of the product is rapidly reduced.

Accordingly, in order to improve crystalline characteristics and reduce defect density through an increase of film thickness, and to improve characteristics of a light emitting device and an electronic device by increasing electrical reliability, a gallium nitride thin film on sapphire substrate is required, wherein a bending is maintained and does not increase even though the thickness of the gallium nitride film increases.

In this respect, the US Patent No. 6,528,394 discloses a method of growing an aluminum nitride layer of a concave-convex shaped structure between a gallium nitride layer and a sapphire substrate to reduce surface stress between the gallium nitride layer and the sapphire substrate, wherein the surface stress causes bending deformation. The Korean Patent Application No. 2004-5585, and corresponding US Patent Application 2005/167683, disclose a gallium nitride thin film on sapphire substrate having reduced bending deformation through control in size and distribution density of an aluminum nitride having a concave-convex shaped structure.

SUMMARY OF THE INVENTION

To solve the above described and/or other problems, the present invention provides a gallium nitride thin film on sapphire substrate and a method for manufacturing the same, in which bending deformation is remarkably reduced to improve characteristics and uniformity of a light emitting diode and an electronic device which are final products.

Additional aspects and/or advantages of the invention will be set forth in part in the description which follows and, in part, will be apparent from the description, or may be learned by practice of the invention.

The invention is defined by the appended independent claims and preferred embodiments are set forth in the dependent claims.

BRIEF DESCRIPTION OF THE DRAWINGS

The above and/or other aspects and advantages of the present invention will become apparent and more readily appreciated from the following detailed description, taken in conjunction with the accompanying drawings of which:

FIG. 1 is a graph illustrating a bending range depending on a thickness of a gallium nitride film in a gallium nitride thin film on sapphire substrate according to the related art;

FIG 2 is a flowchart illustrating process operations of manufacturing a gallium nitride thin film on sapphire substrate according to the present invention;

FIGS. 3A and 3B illustrate a result taken by a three-dimensional interference microscope and a result taken by a two-dimensional microscope with respect to a hexagonal etching trench formed on a sapphire substrate in accordance with the present invention;

FIG. 4 illustrates a method of measuring a curvature radius of a sapphire substrate on which a gallium nitride thin film is grown; and

FIG. 5 is a comparison graph illustrating a curvature radius of a laminate substrate according to the present invention and a curvature radius of a laminate substrate according to the related art depending on thickness of a gallium nitride thin film.

## DETAILED DESCRIPTION OF THE PREFERRED EMBODIMENTS

Reference will now be made in detail to embodiments of the present invention, examples of which are illustrated in the accompanying drawings, wherein like reference numerals refer to the like elements throughout. The embodiments are described below in order to explain the present invention by referring to the figures.

In the present invention, in order to manufacture a gallium nitride thin film on sapphire substrate, after an etching trench structure is formed by primary nitridation and hydrogen chloride treatment of a sapphire substrate, a gallium nitride is grown on the sapphire substrate by secondary nitradation to obtain a gallium nitride thin film on sapphire substrate having reduced bending characteristics of a curvature radius or greater expressed by Equation 1.

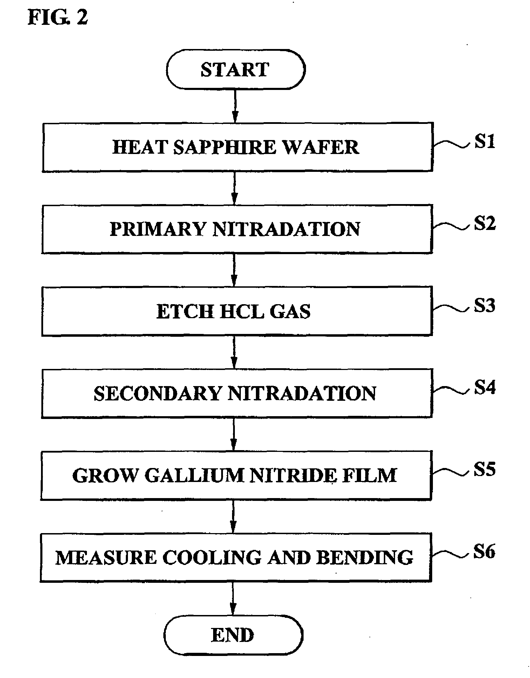

FIG 2 is a flowchart illustrating process operations of manufacturing a gallium nitride thin film on sapphire substrate according to the present invention.

First, a sapphire substrate is heated (S1), and an ammonia gas is flowed onto the heated sapphire substrate at a high temperature of more than 900°C to nitridate the substrate (first nitridation) (S2). Aluminum corresponding to III-group atom is reacted with a nitrogen atom of the ammonia gas by such nitridation to form III-group nitride crystal of aluminum nitride.

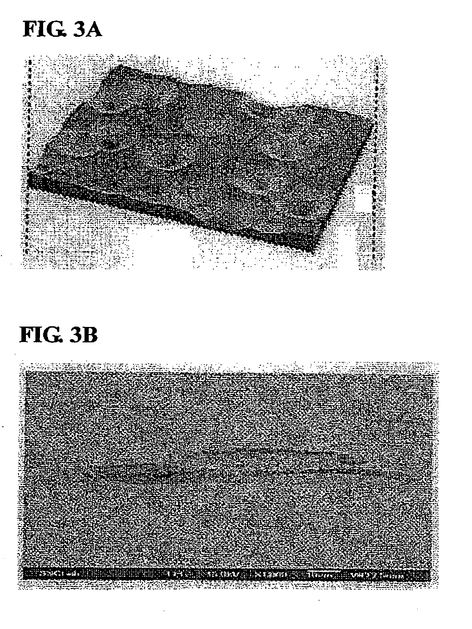

A hydrogen chloride (HCl) gas is supplied to the sapphire substrate at a temperature of more than 900°C (S3). The aluminium nitride crystal and a surface pf the sapphire substrate therebelow are etched by the hydrogen chloride gas to form a hexagonal trench structure. FIG. 3A illustrates a result taken by a three-dimensional interference microscope and FIG. 3B illustrates a result taken by a two-dimensional microscope with respect to the etching trench structure formed in accordance with the present invention. The etching trench structure formed by the process of the hydrogen chloride gas according to the present invention has a height of less than 0.5 $\mu$m and a width in the range of 50 $\mu$m to 60 $\mu$m. Preferably, the number of the etching trench structures is in the range of 500 to 900 par 1 mm$^2$. A relative area of the surface of the sapphire substrate increases due to such a trench structure.

Next, a mixture gas of ammonia and hydrogen chloride is supplied to the sapphire substrate where the hexagonal etching trench structure is formed, at a temperature of more than 900°C to perform secondary nitradation (S4). The secondary nitradation is based on the method disclosed in US Patent No. 6,528,394. The frequency of an aluminum nitride concave-convex structure formed on the sapphire substrate remarkably increases as a relative surface area of the sapphire substrate increases due to the trench structure previously formed, whereby surface stress generated between sapphire and gallium nitride is remarkably reduced. According to the present invention, the aluminum nitride concave-convex structure has a height less than 150 nm and a width in the range of 10 nm to 100 nm, and the number of concave-convex structures is in the range of 25 to 500 per 1 $\mu$m$^2$.

After a gallium nitride thin film is formed on the secondarily nitradated sapphire substrate (S5) and then cooled (S6), a gallium nitride thin film on sapphire substrate is obtained. The gallium nitride thin film is grown by a metal organic chemical vapor deposition (MOCVD) method or a hydride vapor phase epitaxy (HVPE) method at a temperature more than 900°C, preferably in the range of 950°C to 1050°C. At this time, the gallium nitride thin film has a growth thickness of several $\mu$m or greater. Preferably, the gallium nitride thin film has a growth thickness in the range of 0.5 $\mu$m to 20 $\mu$m, and more preferably, less than 10 $\mu$m so as to satisfy a curvature radius according to the present invention.

The cooling operation is performed at a room temperature, and a bending which is convex upwardly occurs in the laminate during the cooling operation. The bending is caused by a difference (about 35%) in thermal expansion coefficients between the sapphire substrate and the gallium nitride film, wherein sapphire having a relatively greater thermal expansion coefficient is more contracted.

The gallium nitride thin film on sapphire substrate of the present invention manufactured as above has a greater range than a curvature radius value defined by Equation 1 when the curvature radius is measured.

Furthermore, when the gallium nitride thin film on sapphire substrate having a small bending range is manufactured as above, a growth time period of single crystalline gallium nitride is increased to form a single crystalline gallium nitride film having a thickness of 100 $\mu$m. In this case, the single crystalline gallium nitride film is separated from the sapphire substrate by a conventional separation method to obtain a freestanding single crystalline gallium nitride film. The gallium nitride substrate obtained as above can be used as a seed substrate for re-growth of single crystalline GaN due to having a bending range less than that of the existing substrate.

Hereinafter, the present invention will be described in more detail through an example. It is to be understood that the following example is exemplary and explanatory to assist understanding of the present invention but is not intended to limit the scope of the invention as claimed.

Example 1

An ammonia gas of 2000 sccm to 4000 sccm was injected onto a sapphire substrate 11 having a diameter of 2 inches and a thickness of 430 $\mu$m for one minute to one and a half minutes to form an aluminum nitride crystal having a concave-convex structure. Subsequently, a hydrogen chloride gas of 500 seem to 1000 seem was injected onto the sapphire substrate 11 for two minutes to three minutes to etch the aluminum nitride concave-convex structure and the sapphire surface below the concave-convex structure, whereby a hexagonal trench structure was formed.

Next, after ammonia and hydrogen chloride are injected onto the etched sapphire substrate at a flow rate of 12:1 to nitridate the sapphire substrate, a gallium nitride film was grown on the sapphire substrate by the HVPE method at a temperature in a range of 950°C to 1050°C. At this time, the ammonia gas was supplied as a nitrogen component (V-group) required for growth of gallium nitride, and the gallium chloride gas obtained by reaction between gallium and a hydrogen chloride gas was supplied as a gallium component (III-group), wherein a ratio of the V-group/III-group gases was in a range of 5 to 10.

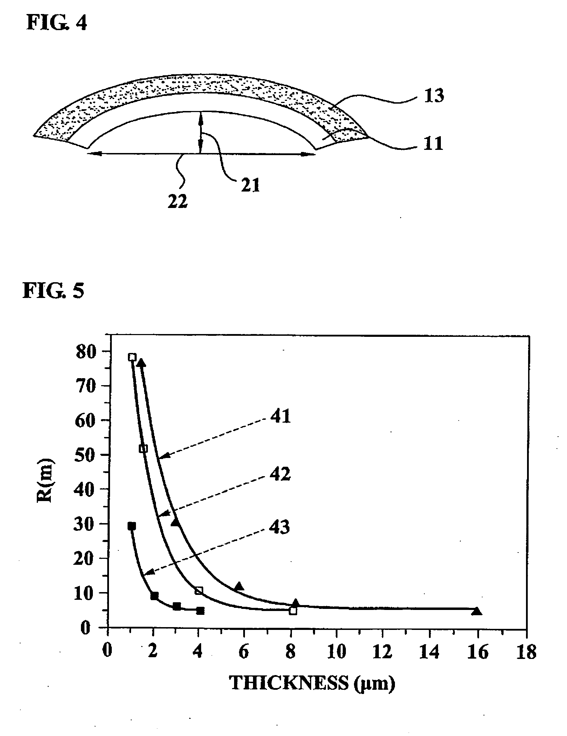

The curvature radius according to the thickness of the gallium nitride thin film with respect to the gallium nitride thin film on sapphire substrate was measured as shown in FIG. 4. Specifically, after the sapphire substrate 11, on which the gallium nitride film 13 was grown, was arranged on a flat plate to upwardly put a convex surface, the thickness corresponding to the center portion of the substrate was measured and then the substrate was turned upside down to again measure its center portion, whereby the height difference 21 ($\Delta$H) was measured and the curvature radius R corresponding to a fixed range of the substrate bending was calculated by the equation $R=D^2/8\Delta H$ using the measured height difference 21 ($\Delta$H) and the diameter 22 (D=50 mm), as expressed in Table 1 below.

[Table 1]

| Film thickness ($\mu$m) of gallium nitride | Curvature radius (R) (m) | Substrate |
|---|---|---|
| 1.4 | 76.5 | Sapphire (0001) Thickness=430 $\mu$m |
| 2.9 | 30.4 | |
| 5.7 | 12.5 | |
| 8.1 | 7.5 | |
| 15.9 | 5.2 | |

Comparable Example 1

In this comparable example 1, a gallium nitride film was grown directly on a sapphire substrate by using a conventional MOCVD method to obtain a gallium nitride thin film on sapphire substrate (same as shown in FIG. 1). Afterwards, a curvature radius R according to the thickness of the gallium nitride film was measured as shown in Table 2 below, in the same manner as the aforementioned example 1 of the present invention.

[Table 2]

| Film thickness ($\mu$m) of gallium nitride | Curvature radius (R) (m) | Substrate |
|---|---|---|
| 1 | 29.6 | Sapphire (0001) Thickness= 430$\mu$m |
| 2 9.4 | | |
| 3 | 6.5 | |
| 4 | 5.4 | |

Comparable Example 2

In this comparable example 2, an aluminum nitride concave-convex structure was formed on a sapphire substrate 11 in accordance with the method disclosed in Korean Patent Application No. 2004-5585, with a flow rate of HCl and ammonia in a range of 1:12 during nitradation, and then a gallium nitride film was grown on the sapphire substrate to obtain a gallium nitride thin film on sapphire substrate. Afterwards, a curvature radius R according to the thickness of the gallium nitride film was measured as shown in Table 3 below, in the same manner as the aforementioned example 1 of the present invention.

[Table 3]

| Film thickness ($\mu$m) of gallium nitride | Curvature radius (R) (m) | Substrate |
|---|---|---|
| 1 | 78.1 | Sapphire (0001) |
| 1.5 | 52.1 | Thickness=430$\mu$m |
| 4 | 11.2 | |
| 8 | 5.3 | |
| | | |

When comparing Tables 1 to 3, it can be seen that the gallium nitride thin film on sapphire substrate according to the example 1 of the present invention has a three times greater increase in curvature radius than the laminate of the comparable example 1 manufactured without a trench structure and aluminum nitride concave-convex structure, and also a 30% increase over the laminate of the comparable example 2 manufactured without a trench structure. Specifically, it is noted that bending deformation was remarkably reduced.

The measurement results of the bending according to the example 1 and the comparable examples 1 and 2 are shown in FIG. 5. Referring to FIG. 5, a curve 41 represents the curvature radius of the laminate substrate according to the example 1 of the present invention, and curves 43 and 42 respectively represent curvature radiuses of the laminate substrate according to the comparable examples 1 and 2. Specifically, referring to the equation 1, the curve 41 represents the curvature radius of the gallium nitride thin film on sapphire substrate according to the present invention in a range that $Y_0$ is 6.23 $\pm$1.15, A is 70.04 $\pm$1.92, and T is 1.59 $\pm$0.12, the curve 42 of the comparable example 2 represents the curvature radius in a range that $Y_0$ is 5.44 $\pm$0.55, A is 72.52 $\pm$0.74, and T is 1.15 $\pm$0.04, and the curve 43 of the comparable example 1 represents the curvature radius in a range that $Y_0$ is 5.47 $\pm$0.34, A is 24.13 $\pm$0.50, and T is 0.56 $\pm$0.04. In this case, it is noted that the curvature radius of the comparable example 1 is smaller than that of the present invention.

According to the present invention, after the trench structure is formed on the sapphire substrate and nitradation is performed, single crystal is grown thereon, whereby the bending deformation is remarkably reduced to obtain the gallium nitride thin film on sapphire substrate of which a curvature radius satisfies the specific equation. As the bending of the laminate is reduced, it is possible to improve characteristics and uniformity of the light emitting diode and the electronic device which are final products.

Although a few embodiments of the present invention have been shown and described, the present invention is not limited to the described embodiments. Instead, it would be appreciated by those skilled in the art that changes may be made to these embodiments without departing from the principles of the invention, the scope of which is defined by the claims and their equivalents.

**Claims**

1.  A gallium nitride thin film on sapphire substrate comprising an etching trench structure formed on the sapphire substrate, wherein a function graph of a curvature radius Y according to a thickness X of the gallium nitride film satisfies the following Equation 1 :

[Equation 1]

$$Y = Y_0 + A \cdot e^{-(X-1)/T}$$,

where Y is the curvature radius m, X is the thickness of the gallium nitride film $\mu$m, and $Y_0$, A, and T are positive numbers, **characterized in that** the function graph of the curvature radius Y corresponds to or is located above a function graph drawn when $Y_0$ is 6.23 $\pm$ 1.15, A is 70.04 $\pm$ 1.92, and T is 1.59 $\pm$ 0.12
and that
the etching trench structure has a height less than 0.5 $\mu$m, a width in the range of 50 $\mu$m to 60 $\mu$m, and a frequency in the range of 500 to 900 per 1 mm$^2$.

**2.** A method for manufacturing a gallium nitride thin film on sapphire substrate according to claim 1, comprising:

(a) forming an aluminum nitride crystal by primarily nitridating a sapphire substrate;
(b) forming an etching trench structure having the same shape as that of the aluminum nitride crystal by etching the substrate using HCl gas;
(c) forming an aluminum nitride concave-convex structure by secondarily nitradating the etched sapphire substrate; and
(d) growing a gallium nitride film on the nitradated sapphire substrate.

**3.** The method of claim 2, wherein the primary nitradation is performed under an ambient of ammonia gas.

**4.** The method of claim 3, wherein the primarily nitradating and the secondarily nitradating comprises a heat treatment of a sapphire substrate in $NH_3$ ambient, respectively.

**5.** The method of claim 2, wherein the secondary nitradation is performed under an ambient of mixture gas of ammonia and HCl.

**6.** The method of claim 2, wherein the nitride concave-convex structure of III-group formed after the secondary nitradation has a height less than 150 nm, a width in the range of 10 nm to 100 nm, and a dencity in the range $25/\mu m^2$ to $500/\mu m^2$.

**7.** An electric or electronic device comprising a gallium nitride thin film on sapphire substrate according to claim 1.

**Patentansprüche**

**1.** Galliumnitriddünnfilm auf Saphirsubstrat umfassend eine Ätzgrabenstruktur gebildet auf dem Saphirsubstrat, wobei ein Funktionsgraph eines Krümmungsradius Y gemäß einer Dicke X des Galliumnitridfilms die folgende Gleichung 1 erfüllt

(Gleichung 1)

$$Y = Y_0 + A \times e^{-(X-1)/T},$$

wobei Y der Krümmungsradius m ist, X die Dicke des Galliumnitridfilms in $\mu m$ ist, und $Y_0$, A und T positive Zahlen sind, **dadurch gekennzeichnet, dass** der Funktionsgraph des Krümmungsradius Y oberhalb eines Funktionsgraphen gezogen für $Y_0 = 6, 23 \pm 1,15$, $A = 70,04 \pm 1,92$ und $T = 1,59 \pm 0,12$ angeordnet ist oder diesem entspricht, und dass die Ätzgrabenstruktur eine Höhe von weniger als 0,5 $\mu m$, eine Breite im Bereich von 50 $\mu m$ bis 60 $\mu m$, und eine Frequenz im Bereich von 500 bis 900 pro 1 $mm^2$ aufweist.

**2.** Verfahren zur Herstellung eines Galliumnitriddünnfilms auf Saphirsubstrat gemäß Anspruch 1, umfassend:

(a) Bilden eines Aluminiumnitridkristalls durch primäres Nitridieren eines Saphirsubstrats;
(b) Bilden einer Ätzgrabenstruktur mit der gleichen Form wie die des Aliminiumnitridkristalls durch Ätzen des Substrates unter Verwendung von HCl-Gas;
(c) Bilden einer Aluminiumnitrid-Konkav-konvexstruktur durch sekundäres Nitridieren des geätzten Saphirsubstrats; und
(d) Aufwachsen eines Galliumnitridfilms auf dem nitridierten Saphirsubstrat.

**3.** Verfahren nach Anspruch 2, wobei die primäre Nitridierung in einer Ammoniakgasumgebung durchgeführt wird.

**4.** Verfahren nach Anspruch 3, wobei die primäre Nitridierung bzw. die sekundäre Nitridierung eine Wärmebehandlung eines Saphirsubstrats in einer NH3-Umgebung umfasst.

**5.** Verfahren nach Anspruch 2, wobei die sekundäre Nitridierung in einer Umgebung aus einer Gasmischung aus Ammoniak und HCl durchgeführt wird.

**6.** Verfahren nach Anspruch 2, wobei die Nitrid-Konkav-konvexstruktur der III-Gruppe gebildeten nach der sekundären Nitridierung eine Höhe von weniger als 150 nm, eine Breite im Bereich von 10 nm bis 100 nm und eine Dichte im Bereich von $25/\mu m^2$ bis $500/\mu m^2$ aufweist.

**7.** Ein elektrisches oder elektronisches Gerät umfassend einen Galliumnitriddünnfilm auf Saphirsubstrat gemäß Anspruch 1.

**Revendications**

**1.** Couche mince de nitrure de gallium sur un substrat de saphir, comprenant une structure de tranchées obtenue par gravure formée sous le substrat de saphir, dans laquelle un graphique de fonction représentant le rayon de courbure Y en fonction de l'épaisseur X de la couche de nitrure de gallium satisfait l'équation 1 suivante :

$$\text{Equation 1}$$
$$Y = Y_0 + A \cdot e^{-(X-1)/T}$$

où Y est le rayon de courbure m, X est l'épaisseur de la couche de nitrure de gallium en $\mu m$ et $Y_0$, A et T sont des nombres positifs, **caractérisée en ce que** le graphique de fonction du rayon de courbure Y correspond à ou est situé au-dessus d'un graphique de fonction tracé quand $Y_0$ est égal à $6,23 \pm 1,15$, A est égal à $70,04 \pm 1,92$ et T est égal à $1,59 \pm 0,12$,
et **en ce que** la structure de tranchées obtenue par gravure possède une hauteur inférieure à 0,5 $\mu m$, une largeur située dans la plage allant de 50 $\mu m$ à 60 $\mu m$ et une fréquence située dans la plage allant de 500 à 900 pour 1 $mm^2$.

**2.** Procédé de formation d'une couche mince de nitrure de gallium sur un substrat de saphir selon la revendication 1, comprenant :

(a) la formation d'un nitrure d'aluminium cristallin en effectuant une première nitruration d'un substrat de saphir ;
(b) la formation d'une structure de tranchées obtenue par gravure ayant la même forme que celle du nitrure d'aluminium cristallin par la gravure du substrat au moyen d'HCl gazeux ;
(c) la formation d'une structure concave-convexe de nitrure d'aluminium en effectuant une seconde nitruration du substrat de saphir gravé ; et
(d) la formation d'une couche de nitrure de gallium sur le substrat de saphir nitruré.

**3.** Procédé selon la revendication 2, dans lequel la première nitruration est réalisée sous une atmosphère d'ammoniac gazeux.

**4.** Procédé selon la revendication 3, dans lequel la première nitruration et la seconde nitruration comprennent respectivement un traitement thermique du substrat de saphir sous une atmosphère de $NH_3$.

**5.** Procédé selon la revendication 2, dans lequel la seconde nitruration est réalisée sous une atmosphère comprenant un mélange gazeux contenant de l'ammoniac et de l'HCl.

**6.** Procédé selon la revendication 2, dans lequel la structure concave-convexe de nitrure du groupe III formée après la seconde nitruration possède une hauteur inférieure à 150 nm, une largeur située dans la plage allant de 10 nm à 100 nm et une densité située dans la plage allant de $25/\mu m^2$ à $500/\mu m^2$.

**7.** Dispositif électrique ou électronique, comprenant la couche mince de nitrure de gallium sur un substrat de saphir selon la revendication 1.

## FIG. 1 (RELATED ART)

**FIG. 2**

```
        ┌─────────────┐
        │    START    │
        └─────────────┘
               │
               ▼
   ┌───────────────────────────┐
   │   HEAT SAPPHIRE WAFER     │ ～ S1
   └───────────────────────────┘
               │
               ▼
   ┌───────────────────────────┐
   │    PRIMARY NITRADATION    │ ～ S2
   └───────────────────────────┘
               │
               ▼
   ┌───────────────────────────┐
   │       ETCH HCL GAS        │ ～ S3
   └───────────────────────────┘
               │
               ▼
   ┌───────────────────────────┐
   │   SECONDARY NITRADATION   │ ～ S4
   └───────────────────────────┘
               │
               ▼
   ┌───────────────────────────┐
   │  GROW GALLIUM NITRIDE FILM │ ～ S5
   └───────────────────────────┘
               │
               ▼
   ┌───────────────────────────┐
   │ MEASURE COOLING AND BENDING│ ～ S6
   └───────────────────────────┘
               │
               ▼
        ┌─────────────┐
        │     END     │
        └─────────────┘
```

**FIG. 3A**

**FIG. 3B**

**FIG. 4**

**FIG. 5**

**REFERENCES CITED IN THE DESCRIPTION**

**Patent documents cited in the description**

- US 6528394 B
- KR 20045585

- US 2005167683 A